# EUROPEAN PATENT APPLICATION

(11) **EP 3 296 839 A1**
(43) Date of publication of application: **21.03.2018**
(21) Application number: 17150732.0
(22) Date of filing: 09.01.2017
(51) Int. Cl.: G06F 1/20, H05K 7/20, F25B 39/00

(54) **SYSTEM AND METHOD FOR COOLING A COMPUTER PROCESSOR**

(30) Priority: 20.09.2016 US 201615270038
(71) Applicant: Hardware Labs Performance Systems, Inc, 1140 Quezon City (PH); International Computer Concepts, Inc., Northbrook, IL 60062 (US)
(72) Inventor: YUQUE, Wilbert, 1104 Quezon City (PH); STOLYAR, Alexey, Northbrook, IL 60062 (US)
(74) Representative: Murgitroyd & Company

(57) **Abstract**

A system for cooling one or more computer processors is provided. The system includes a server chassis and one or more server nodes. The server chassis is selectively mountable to a server rack. The one or more server nodes each include a body, at least one of the one or more computer processors, and a refrigeration circuit. The body is selectively mountable to the server chassis. The at least one of the one or more computer processors is disposed on-board the body. The refrigeration circuit is for cooling the at least one computer processor and includes an evaporator and a compressor disposed on-board the body.

## Description

### BACKGROUND

### TECHNICAL FIELD

Embodiments of the invention relate generally to cooling computer processors, and more specifically, to a system and method for cooling computer processors via refrigerant.

### DISCUSSION OF ART

Computer software applications increasingly require faster processing speeds. In order to achieve the required speeds of such applications, many computer processors are "overclocked," e.g., configured to operate at a clock speed/frequency that is faster than the standard speed of the processor as certified by the processor's manufacturer. Overclocking a processor, however, increases the amount of heat generated by the processor during operations (also referred to herein as "heat load"), which can damage the processor if not removed/dissipated in a timely manner.

Many current computer system attempt to control/regulate the increased heat load that results from overclocking a processor via utilizing increasingly larger heat sinks, heat pipes, and/or liquid cooling systems, e.g., non-refrigerant water-based cooling systems. Such cooling systems, however, are hindered in their ability to regulate increased heat loads due to limitations in their ability to dissipate heat into environments having temperatures slightly higher than or equal to ambient temperatures. Such limitations in turn limit the maximum speed at which a processor can be safely overclocked at for extended periods of time. In other words, the maximum overclocking speed of many computer systems is limited by the ambient temperature of their surrounding environment. For example, a liquid cooled Intel^{®} Core i7 5960x operating at 4.6GHz with a 4.3GHz cache will generate about 300W to 400W. In order to overclock such a processor to 5.0GHz and beyond, it is often necessary to increase the voltage, which in turn creates a heat load larger than many liquid cooling systems can safely handle.

As it happens to be, however, some cooling systems utilize refrigeration to cool the interior cavities of server nodes, i.e., the physical casing of a computer that typically houses a mother board and other various electronic components. While such refrigerant based cooling systems can safely handle larger heat loads then the aforementioned liquid cooling systems, they often require the use of large compressors, condensers, and cooling coils to dissipate heat. Accordingly, the compressor, condenser, and cooling coils of such refrigerant based cooling system are typically located in the bottom/tops of a server rack, or outside of the server rack altogether, thus requiring extensive plumbing to deliver refrigerant to a server node contained within the server rack. Locating the compressor, condenser, cooling coils, and/or other components of a refrigeration based cooling system, away from the server nodes they are intended to cool makes such systems, and the corresponding server nodes, difficult to install into a server rack and/or move within the same rack and/or between different server racks.

What is needed, therefore, is an improved system and method for cooling a computer processor.

### BRIEF DESCRIPTION

According to a first aspect, there is provided a system for cooling one or more computer processors, the system comprising: a server chassis that is selectively mountable to a server rack; one or more server nodes each including: a body that is selectively mountable to the server chassis; at least one of the one or more computer processors disposed on-board the body; a refrigeration circuit for cooling the at least one computer processor; and wherein the refrigeration circuit includes an evaporator and a compressor disposed on-board the body.

The evaporator may be disposed on the at least one computer processor.

The refrigeration circuit may further include a condenser disposed on-board the body.

The refrigeration circuit may include a metering device disposed on-board the body.

The refrigeration circuit may further include a filter disposed on-board the body.

At least three server nodes may be selectively mounted to the server chassis.

The body of each of the server nodes includes a first end and a second end, the at least one computer processor and the compressor of a first server node and of a second node of the at least three server nodes are disposed at the first end and at the second end, respectively, the at least one computer processor and the compressor of a third server node of the at least three server nodes are disposed in the first end, and the server nodes are mounted to the server chassis such that the first ends of the first and of the second server nodes are arranged opposite of the first end of the third server node.

The at least one computer processor may be disposed on a circuit board disposed on-board the body such that the circuit board is parallel to a vertical axis of the server rack when the server chassis is mounted to the server rack.

According to a second aspect, there is provided a server node comprising: a body; at least one computer processor disposed on-board the body; a refrigeration circuit for cooling the at least one computer processor; and wherein the refrigeration circuit includes an evaporator and a compressor disposed on-board the body.

The evaporator may be disposed on the at least one computer processor.

The refrigeration circuit may further include a condenser disposed on-board the body.

The refrigeration circuit may further include a metering device disposed on-board the body.

The refrigeration circuit may further include a filter disposed on-board the body.

The body may be selectively mountable to a server rack.

The body may be selectively mountable to a server chassis that is selectively mountable to a server rack. The at least one computer processor may be disposed on a circuit board disposed on-board the body such that the circuit board is parallel to a vertical axis of the server rack when the server chassis is mounted to the server rack.

The at least one computer processor may be disposed at a first end of the body and the compressor is disposed at a second end of the body.

The at least one computer processor and the compressor may be disposed at a first end of the body.

According to a third aspect, there is provided a method for cooling a computer processor disposed on-board a server node, the method comprising: compressing a refrigerant via a compressor disposed on-board the server node; and directing the refrigerant through an evaporator disposed on-board the server node and in heating-contact with the computer processor.

The method may further comprise automatically adjusting the compressor in relation to a usage level of the computer processor via a controller disposed on-board the server node.

### DRAWINGS

The present invention will be better understood from reading the following description of non-limiting embodiments, with reference to the attached drawings, wherein below:
FIG. 1 is a perspective view of a system for cooling one or more computer processors in accordance with an embodiment of the present invention;
FIG. 2 is another perspective view of the system of FIG. 1 in accordance with an embodiment of the present invention;
FIG. 3 is a diagram of the system of FIG. 1, wherein a server chassis of the system of FIG. 1 is selectively mounted to a server rack, in accordance with an embodiment of the present invention;
FIG. 4 is a perspective view of a server node of the system of FIG. 1 in accordance with an embodiment of the present invention;
FIG. 5 is a schematic diagram of the server node of FIG. 4 in accordance with an embodiment of the present invention;
FIG. 6 is another perspective view of the server node of FIG. 4 in accordance with an embodiment of the present invention; and
FIG. 7 is a perspective view of another server node of the system of FIG. 1 in accordance with an embodiment of the present invention.

### DETAILED DESCRIPTION

Reference will be made below in detail to exemplary embodiments of the invention, examples of which are illustrated in the accompanying drawings. Wherever possible, the same reference characters used throughout the drawings refer to the same or like parts, without duplicative description.

As used herein, the terms "substantially," "generally," and "about" indicate conditions within reasonably achievable manufacturing and assembly tolerances, relative to ideal desired conditions suitable for achieving the functional purpose of a component or assembly. The term "real-time," as used herein, means a level of processing responsiveness that a user senses as sufficiently immediate or that enables the processor to keep up with an external process. As used herein, "electrically coupled", "electrically connected", "electrical communication", and "communication" mean that the referenced elements are directly or indirectly connected such that an electrical current, or other communication medium, may flow from one to the other. The connection may include a direct conductive connection, i.e., without an intervening capacitive, inductive or active element, an inductive connection, a capacitive connection, and/or any other suitable electrical connection. Intervening components may be present. As also used herein, the term "selectively mountable" means capable of being physically fixed/attached/connected/mounted and unfixed/detached/disconnected/un-mounted on or within an object within a reasonable short period of time.

Additionally, while the embodiments disclosed herein are described with respect to a system and method for cooling a computer processor, it is to be understood that embodiments of the present invention may be applicable to other systems which require an embedded component to be cooled via refrigerant.

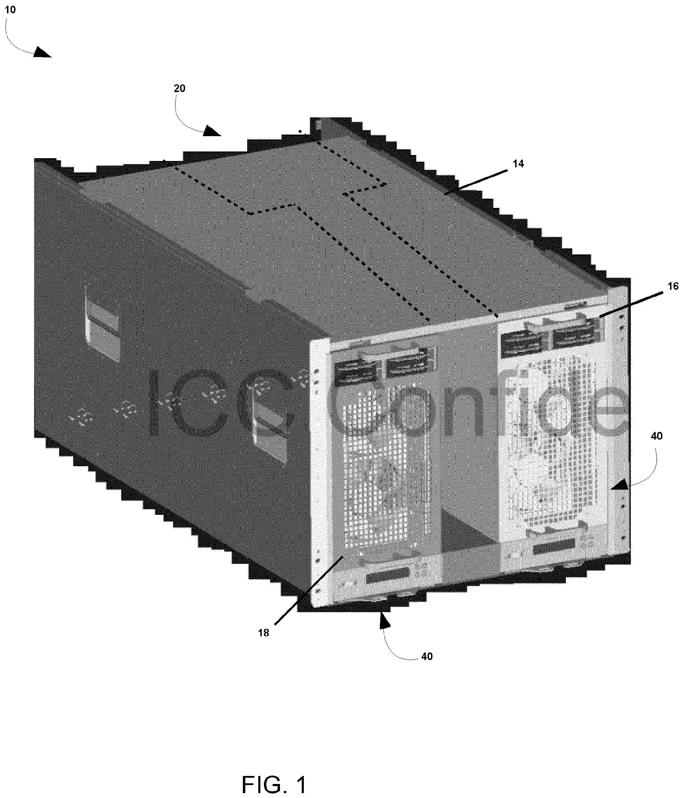

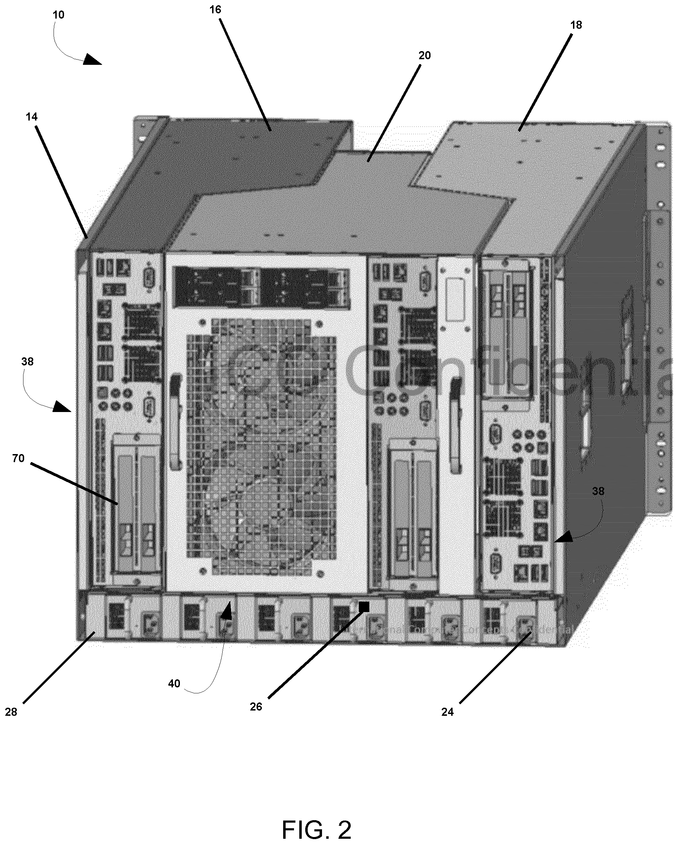

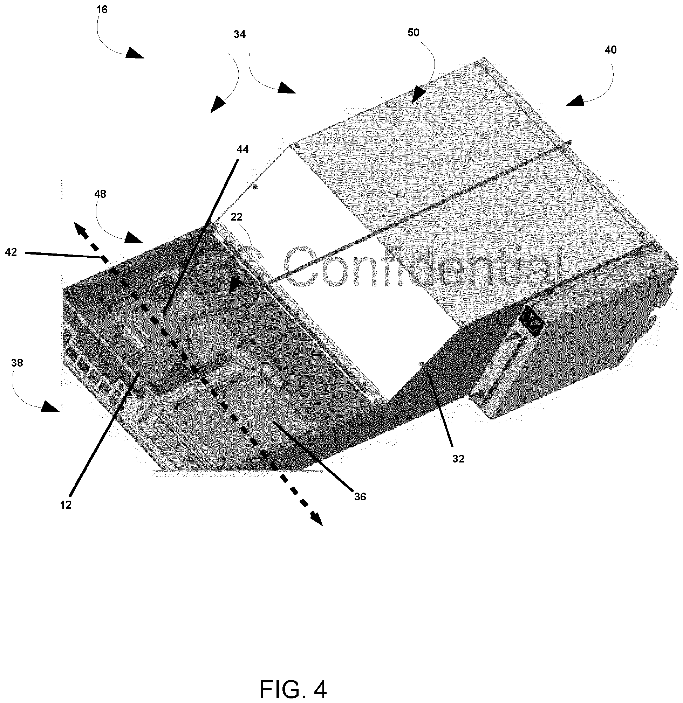

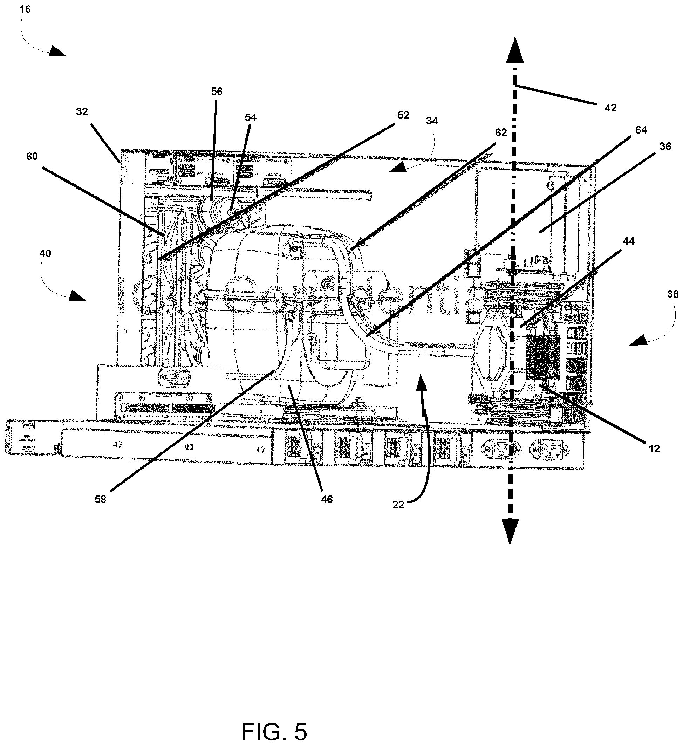

Referring now to FIGS. 1 and 2, a first/front side (FIG. 1) and a second/rear side (FIG. 2) of a system 10 for cooling one or more computer processors (12 in FIGS. 4-7) in accordance with embodiments of the present invention is shown. As will be appreciated, in embodiments, the system 10 includes a server chassis 14, and one or more server nodes 16, 18, and 20 which may be selectively mountable to the server chassis 14. As used herein, the term "server node" refers to a physical computing apparatus, e.g., a desktop and/or rack server, that typically includes a motherboard, processors, RAM, power supplies / conditioners, and/or other electrical equipment generally found in computing systems. As will be further appreciated, each of the server nodes 16, 18, and 20 includes a refrigeration circuit (generally marked as 22 in FIGS. 4-7) for cooling the at least one processor 12.

As shown in FIGS. 1 and 2, the server chassis 14 is configured to house the one or more server nodes 16, 18, 20. Accordingly, the server chassis 14 may include a power supply 24, and one or more communication ports, e.g., Ethernet ports, 26 for allowing remote access/control of the server chassis 14 and/or server nodes 16, 18, 20. The server chassis 14 may also include a cooling controller 28 that regulates/controls the refrigeration circuits 22 in each of the server nodes 16, 18, 20. For example, in embodiments, the cooling controller 28 may automatically adjust the components of the refrigeration circuit 22 in relation to a usage level of the one or more computer processors 12 in real-time or near real-time. As will also be appreciated, in embodiments, the cooling controller 28 may be disposed on-board the server nodes 16, 18, 20.

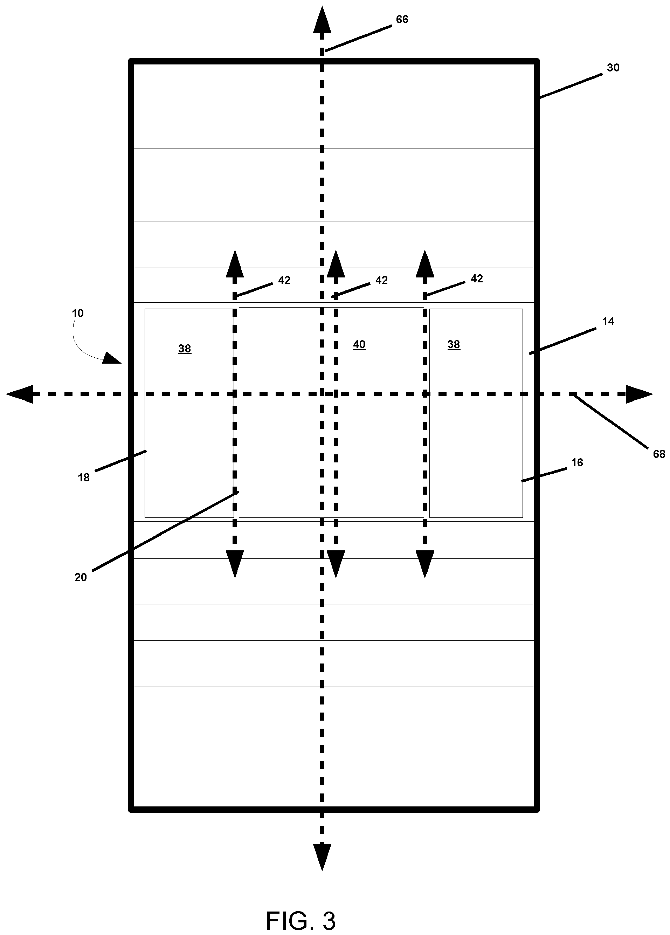

As shown in FIG. 3, in embodiments, the server chassis 14 may be selectively mountable to a server rack 30. The server rack 30 may be a standard server rack of the type typically found in a "server farm" / data processing center that contains a plurality of servers. As will be appreciated, in embodiments, the server chassis 14 may require 8 rack units ("8U") in the server rack.

Turning now to FIGS. 4-6, a first embodiment of the server node 16 is shown. The server node 16 includes a body 32, at least one of the one or more computer processors 12, and a refrigeration circuit 22. The body 32 may define an interior cavity 34 configured to house and protect electronic components such as the processor 12, a motherboard 36, RAM, and/or various disk drives and other electrical components. The body 32 may have an elongated shape, e.g., rectangular, with a defined first/front end 38 and a defined second/rear end 40, and may be selectively mountable to the server chassis 14 via known means in the art, e.g., tracks/rails, clips, screws, and/or other types of fasteners. As will be appreciated, however, the body 32 may also be selectively mountable to the server rack 30 independently of the server chassis 14.

The processor 12 may be disposed on-board the server node 16. While the embodiments depicted herein show the processor disposed within the interior cavity 34, it is to be understood, that in other embodiments the processor 12 may be fully or partially disposed on a surface of the body 32. Further, the processor 12 may be disposed on a standard motherboard 36 having a longitudinal axis 42 that is itself disposed on-board the server node 16. In embodiments, the processor 12 and/or the motherboard 36 may be disposed at the first/front end 38 of the server node.

As further shown in FIGS. 4-6, and as stated above, the server node 16 includes a refrigeration circuit 22 for cooling the processor 12. In embodiments, the refrigeration circuit 22 may include an evaporator 44 and a compressor 46 and be fully contained to the server node 16, i.e., the server node 14 can be mounted and dismounted from the server rack 30 and/or the server chassis 14 without the need to dismantle the refrigeration circuit 22. In embodiments, the refrigerant flowing through the refrigeration circuit 22 may be a non-flammable, and/or non-toxic, HFC refrigerant such as R134A, R404A, R507A, or R407A or other suitable refrigerant. In embodiments, the refrigerant may have a boiling temperature of at least -10 °C or lower.

As will be appreciated, in embodiments, the evaporator 44 may be disposed on-board the server node 16 so as to be in heating-contact with the processor 12. As used herein, the term heating-contact means that the referenced objects, e.g., the evaporator 44 and the processor 12, are located in relation to each other such that the referenced objects can exchange thermal energy. For example, in embodiments, the evaporator 44 may be disposed on the processor 12. Accordingly, the evaporator 44 transfers heat from the processor 12 to refrigerant flowing within the refrigeration circuit 22, thus cooling the processor 12.

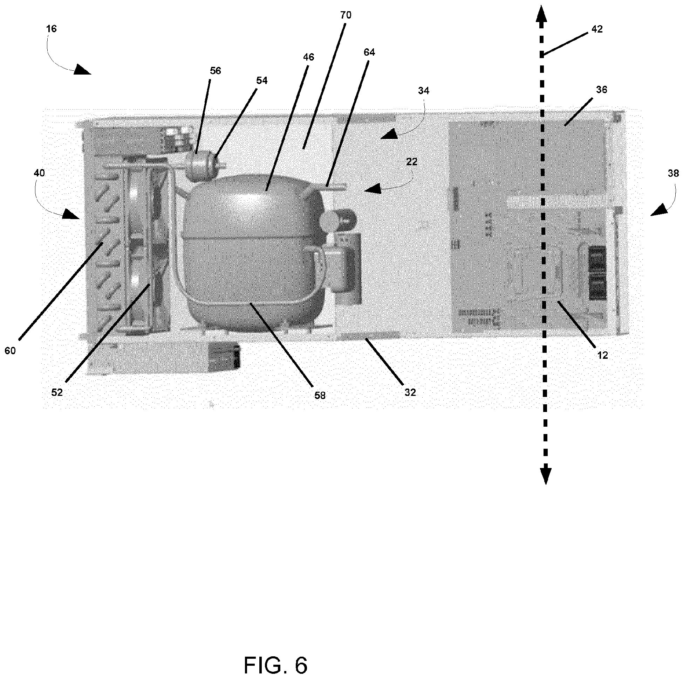

As also shown in FIGS. 4-6, the compressor 46 may be disposed on-board the server node 16. For example, in embodiments, the compressor 46 may be of a compact design, e.g., the compressor 46 may have a rated capacity of at least 550 W or greater at -25 °C with a maximum overall width of 150 mm or less so as to provide for a density of 3 nodes in an 8U rack space while having a weight of 50 lbs or less, and be disposed at the second/rear end 40 of the server node 16. Accordingly, the interior cavity 34 of the server node may be divided into a front compartment (48 FIG. 4), that houses traditional computer components, e.g., the motherboard 36 and processor 12, and a rear compartment (50 FIG. 4), that houses the compressor 46. As will be understood, in embodiments, the server node 16 may include a support structure (70 in FIG. 6) for preventing the interior cavity 34 from collapsing, or the compressor 46 from falling through the body 32, due to the weight of the compressor 46 in the event that the server node 16 is turned on its side. The support structure 70 may be made of metal, plastic, composite fiber, and/or another other appropriate material(s). In embodiments, the support structure 70 may be a plate mounted to the body 32 and to the compressor 46 such that the compressor 46 is restricted from moving within the interior cavity 34. In embodiments, the support structure 70 may be a "U" shaped bracket, which in some embodiments, may be 10 mm.

As will be further appreciated, the refrigeration circuit may further include a condenser 52, a metering device 54, a strainer/filter/drier 56, and/or other refrigeration components also disposed on-board the server node 16 / body 32.

Accordingly, in operation, refrigerant may be compressed by the compressor 46 and sent via line 58 to the condenser 52, which may include a series of condensing coils 60 configured to dissipate heat from the refrigerant to the outside environment. As is also to be appreciated, the coils 60 may be made from machined finned copper tubing so as to maximize heat transfer by eliminating mechanical joints and thermal resistance. In embodiments, the coils 60 may be arranged in a diagonally staggered orientation relative to each other so as to maximize airflow and turbulation, while conserving the amount of space occupied by the coils 60. In embodiments, the finned copper tubing 60 may have ends that are swaged so as to allow a U-bend copper joint to be recessed and brazed, thereby keeping a lateral profile of a 120 mm x 2 fan form factor condenser within a width of 150 mm.

The refrigerant may then flow from the condenser 52 to the metering device 54 which reduces the pressure and temperature of the refrigerant. In embodiments, the metering device 54 may be capillary tubing and/or a thermostatic expansion valve. As will be appreciated, in embodiments, the refrigerant may also flow through the filter 56 on its way from the condenser 52 to the metering device 54. As will be appreciated, the filter 56 may remove contaminants from the refrigerant. The refrigerant then flows via line 62, which may be flexible, from the metering device 54 to the evaporator 44 where it absorbs heat from the processor 12 such that the refrigerant increases in temperature. As will be appreciated, in embodiments, the transfer of heat from the processor 12 into the refrigerant via the evaporator 44 may cause the refrigerant to change state, e.g., from liquid to a gas. The heated refrigerant then flows via line 64, which may be flexible, back to the compressor 46, thus completing the refrigeration circuit 22.

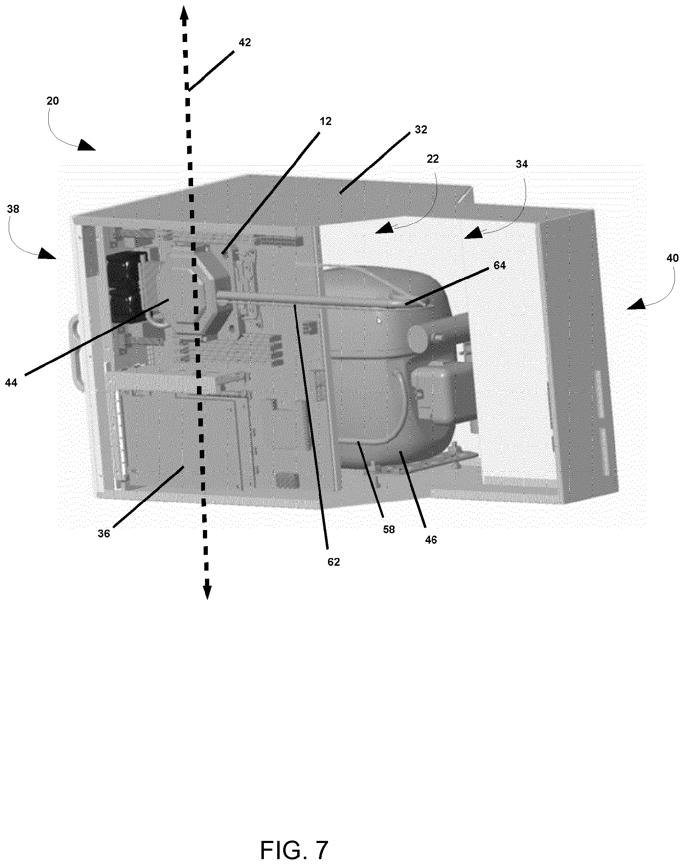

Referring now to FIG. 7, a second embodiment of the server node 20 is shown. As will be appreciated, the server node 20 is nearly identical to server node 16 with the exception that the motherboard 36, processor 12, and the compressor 46 are located in the same first end 38 of the body 32, e.g., the processor 12 and the compressor 46 are located side-by-side, as opposed to tandem.

Accordingly, and as illustrated in FIGS. 1-3, in embodiments, three server nodes 16, 18, and 20 may be selectively mounted to the server chassis 14. In such embodiments, server nodes 16 and 18 may be mirror images of each other such that server node 16 is configured to be on a first, e.g., left and/or right, side of server node 20, and server node 18 is configured to be on the opposite side of server node 20 from server node 16. In such embodiments, the server nodes 16, 18, and 20 may be arranged such that the front ends 38 of server nodes 16 and 18 are opposite that of the front end 38 of server node 20.

As is to be further appreciated, when the server nodes 16, 18, and 20 are selectively mounted to the server chassis 14 with the server chassis 14 in turn selectively mounted to the server rack 30, the motherboard/circuit board 36, of one or more of the server nodes 16, 18, 20, is parallel to a vertical axis 66 of the server rack 30, i.e., a horizontal axis 68 of the server rack 30 is perpendicular to a longitudinal axis 42 (also shown in FIGS. 4-7) of the motherboard/circuit board 36. In other words, the normal vector of the plane formed by the motherboard/circuit board 36 is perpendicular to the vertical axis 66 of the server rack 30.

Finally, it is also to be understood that the system 10, may include the necessary electronics, software, memory, storage, databases, firmware, logic/state machines, microprocessors, communication links, displays or other visual or audio user interfaces, printing devices, and any other input/output interfaces to perform the functions described herein and/or to achieve the results described herein. For example, the server chassis 14 may include at least one processor 28, and system memory / data storage structures (70 in FIG. 2), which may include random access memory (RAM) and read-only memory (ROM). The at least one processor of the server chassis 14 and/or the server nodes 16, 18, and 20 may include one or more conventional microprocessors and one or more supplementary co-processors such as math co-processors or the like. The data storage structures discussed herein may include an appropriate combination of magnetic, optical and/or semiconductor memory, and may include, for example, RAM, ROM, flash drive, an optical disc such as a compact disc and/or a hard disk or drive.

Additionally, a software application that provides for automated control and/or remote management of the server chassis 14, server nodes 16, 18, and 20, and/or their corresponding compressors 46, may be read into a main memory of the at least one processors 12, 28 from a computer-readable medium. The term "computer-readable medium", as used herein, refers to any medium that provides or participates in providing instructions to the at least one processors 12, 28 (or any other processor of a device described herein) for execution. Such a medium may take many forms, including but not limited to, non-volatile media and volatile media. on-volatile media include, for example, optical, magnetic, or opto-magnetic disks, such as memory. Volatile media include dynamic random access memory (DRAM), which typically constitutes the main memory. Common forms of computer-readable media include, for example, a floppy disk, a flexible disk, hard disk, magnetic tape, any other magnetic medium, a CD-ROM, DVD, any other optical medium, a RAM, a PROM, an EPROM or EEPROM (electronically erasable programmable read-only memory), a FLASH-EEPROM, any other memory chip or cartridge, or any other medium from which a computer can read.

While in embodiments, the execution of sequences of instructions in the software application causes the at least one processor to perform the methods/processes described herein, hard-wired circuitry may be used in place of, or in combination with, software instructions for implementation of the methods/processes of the present invention. Therefore, embodiments of the present invention are not limited to any specific combination of hardware and/or software.

It is further to be understood that the above description is intended to be illustrative, and not restrictive. For example, the above-described embodiments (and/or aspects thereof) may be used in combination with each other. Additionally, many modifications may be made to adapt a particular situation or material to the teachings of the invention without departing from its scope.

For example, in an embodiment a system for cooling one or more computer processors is provided. The system includes a server chassis and one or more server nodes. The server chassis is selectively mountable to a server rack. The one or more server nodes each include a body, at least one of the one or more computer processors, and a refrigeration circuit. The body is selectively mountable to the server chassis. The at least one of the one or more computer processors is disposed on-board the body. The refrigeration circuit is for cooling the at least one computer processor and includes an evaporator and a compressor disposed on-board the body. In certain embodiments, the evaporator is disposed on the at least one computer processor. In certain embodiments, the refrigeration circuit further includes a condenser disposed on-board the body. In certain embodiments, the refrigeration circuit further includes a metering device disposed on-board the body. In certain embodiments, the refrigeration circuit further includes a filter disposed on-board the body. In certain embodiments, at least three server nodes are selectively mounted to the server chassis. In certain embodiments, the body of each of the server nodes includes a first end and a second end, the at least one computer processor and the compressor of a first server node and of a second server node of the at least three server nodes are disposed at the first end and at the second end, respectively, and the at least one computer processor and the compressor of a third server node of the at least three server nodes are disposed in the first end. In such embodiments, the server nodes are mounted to the server chassis such that the first ends of the first and of the second server nodes are arranged opposite of the first end of the third server node. In certain embodiments, the at least one computer processor is disposed on a circuit board disposed on-board the body such that the circuit board is parallel to a vertical axis of the server rack when the server chassis is mounted to the server rack.

Other embodiments provide for a server node. The server node includes a body, at least one computer processor, and a refrigeration circuit. The at least one computer processor is disposed on-board the body. The refrigeration circuit is for cooling the at least one computer processor and includes an evaporator and a compressor disposed on-board the body. In certain embodiments, the evaporator is disposed on the at least one computer processor. In certain embodiments, the refrigeration circuit further includes a condenser disposed on-board the body. In certain embodiments, the refrigeration circuit further includes a metering device disposed on-board the body. In certain embodiments, the refrigeration circuit further includes a filter disposed on-board the body. In certain embodiments, the body is selectively mountable to a server rack. In certain embodiments, the body is selectively mountable to a server chassis that is selectively mountable to a server rack. In certain embodiments, the at least one computer processor is disposed on a circuit board disposed on-board the body such that the circuit board is parallel to a vertical axis of the server rack when the server chassis is mounted to the server rack. In certain embodiments, the at least one computer processor is disposed at a first end of the body and the compressor is disposed at a second end of the body. In certain embodiments, the at least one computer processor and the compressor are disposed at a first end of the body.

Yet still other embodiments provide for a method for cooling a computer processor disposed on-board a server node. The method includes: compressing a refrigerant via a compressor disposed on-board the server node; and directing the refrigerant through an evaporator disposed on-board the server node and in heating-contact with the computer processor. In certain embodiments, the method further includes automatically adjusting the compressor in relation to a usage level of the computer processor via a controller disposed on-board the server.

Accordingly, by utilizing a refrigerant circuit 22 to cool one or more processors 12, some embodiments of the present invention provide for the ability to overclock the processors at speeds greater than cooling systems that utilize heat sinks or liquid coolants., e.g., non-refrigerants. For example, some embodiments provide for an Intel Core i7 5960x to be overclocked to 5.0 GHz with a 4.6GHz cache such that processor generates 500W to 580W but is kept at temperatures up to 56 °C with the evaporator 44 at a temperature of -28 °C to -35 °C.

Moreover, because the refrigerant circuit 22 is formed from components, e.g., the evaporator 44, compressor 46, condenser 52, metering device 54, and/or filter 56, disposed on-board a server node 16, 18, 20, some embodiments of the invention provide for a refrigerant based cooling system 10 that does not require extensive plumbing and/or large compressors contained in a lower server rack compartment or external of the server rack altogether. Accordingly, some embodiments of the present invention provide for a refrigerant based cooling system that facilitates easy installation and/or movement of the server nodes 16, 18, 20 into and/or between server rack 30 locations, or between other server racks (not shown).

Additionally, while the dimensions and types of materials described herein are intended to define the parameters of the invention, they are by no means limiting and are exemplary embodiments. Many other embodiments will be apparent to those of skill in the art upon reviewing the above description. The scope of the invention should, therefore, be determined with reference to the appended claims, along with the full scope of equivalents to which such claims are entitled. In the appended claims, the terms "including" and "in which" are used as the plain-English equivalents of the respective terms "comprising" and "wherein." Moreover, in the following claims, terms such as "first," "second," "third," "upper," "lower," "bottom," "top," etc. are used merely as labels, and are not intended to impose numerical or positional requirements on their objects. Further, the limitations of the following claims are not written in means-plus-function format and are not intended to be interpreted based on 35 U.S.C. § 112(f), unless and until such claim limitations expressly use the phrase "means for" followed by a statement of function void of further structure.

This written description uses examples to disclose several embodiments of the invention, including the best mode, and also to enable one of ordinary skill in the art to practice the embodiments of invention, including making and using any devices or systems and performing any incorporated methods. The patentable scope of the invention is defined by the claims, and may include other examples that occur to one of ordinary skill in the art. Such other examples are intended to be within the scope of the claims if they have structural elements that do not differ from the literal language of the claims, or if they include equivalent structural elements with insubstantial differences from the literal languages of the claims.

As used herein, an element or step recited in the singular and proceeded with the word "a" or "an" should be understood as not excluding plural of said elements or steps, unless such exclusion is explicitly stated. Furthermore, references to "one embodiment" of the present invention are not intended to be interpreted as excluding the existence of additional embodiments that also incorporate the recited features. Moreover, unless explicitly stated to the contrary, embodiments "comprising," "including," or "having" an element or a plurality of elements having a particular property may include additional such elements not having that property.

Since certain changes may be made in the above-described invention, without departing from the spirit and scope of the invention herein involved, it is intended that all of the subject matter of the above description shown in the accompanying drawings shall be interpreted merely as examples illustrating the inventive concept herein and shall not be construed as limiting the invention.

## Claims

1. A system for cooling one or more computer processors, the system comprising:
a server chassis that is selectively mountable to a server rack;
one or more server nodes each including:
a body that is selectively mountable to the server chassis;
at least one of the one or more computer processors disposed on-board the body;
a refrigeration circuit for cooling the at least one computer processor; and
wherein the refrigeration circuit includes an evaporator and a compressor disposed on-board the body.

2. The system of claim 1, wherein the evaporator is disposed on the at least one computer processor.

3. The system of claim 1, wherein, the refrigeration circuit further includes a condenser disposed on-board the body.

4. The system of claim 1, wherein the refrigeration circuit further includes a metering device disposed on-board the body.

5. The system of claim 1, wherein the refrigeration circuit further includes a filter disposed on-board the body.

6. The system of claim 1, wherein at least three server nodes are selectively mounted to the server chassis.

7. The system of claim 6, wherein
the body of each of the server nodes includes a first end and a second end,
the at least one computer processor and the compressor of a first server node and of a second server node of the at least three server nodes are disposed at the first end and at the second end, respectively,
the at least one computer processor and the compressor of a third server node of the at least three server nodes are disposed in the first end, and
the server nodes are mounted to the server chassis such that the first ends of the first and of the second server nodes are arranged opposite of the first end of the third server node.

8. The system of claim 1, wherein the at least one computer processor is disposed on a circuit board disposed on-board the body such that the circuit board is parallel to a vertical axis of the server rack when the server chassis is mounted to the server rack.

9. A server node comprising:
a body;
at least one computer processor disposed on-board the body;
a refrigeration circuit for cooling the at least one computer processor; and
wherein the refrigeration circuit includes an evaporator and a compressor disposed on-board the body.

10. The server node of claim 9, wherein the evaporator is disposed on the at least one computer processor.

11. The server node of claim 9, wherein, the refrigeration circuit further includes a condenser disposed on-board the body.

12. The server node of claim 9, wherein the refrigeration circuit further includes a metering device disposed on-board the body.

13. The server node of claim 9, wherein the refrigeration circuit further includes a filter disposed on-board the body.

14. A method for cooling a computer processor disposed on-board a server node, the method comprising:
compressing a refrigerant via a compressor disposed on-board the server node; and
directing the refrigerant through an evaporator disposed on-board the server node and in heating-contact with the computer processor.

15. The method of claim 14, wherein the method further comprises:
automatically adjusting the compressor in relation to a usage level of the computer processor via a controller disposed on-board the server node.
